# EUROPEAN PATENT APPLICATION

(11) **EP 2 690 941 A1**
(43) Date of publication of application: **29.01.2014**
(21) Application number: 12760032.8
(22) Date of filing: 21.03.2012
(51) Int. Cl.: H05K 3/46, H05K 1/11, H05K 3/40

(54) **WIRING SUBSTRATE**

(30) Priority: 24.03.2011 JP 2011065226
(71) Applicant: Murata Manufacturing Co., Ltd., Nagaokakyo-shi, Kyoto 617-8555 (JP)
(72) Inventor: ITO, Satoshi, Nagaokakyo-shi Kyoto 617-8555 (JP); MORIYA, Yoichi, Nagaokakyo-shi Kyoto 617-8555 (JP); KANAMORI, Tetsuo, Nagaokakyo-shi Kyoto 617-8555 (JP); YAGI, Yukihiro, Nagaokakyo-shi Kyoto 617-8555 (JP); YAMAMOTO, Yuki, Nagaokakyo-shi Kyoto 617-8555 (JP)
(74) Representative: Zinkler, Franz
(86) International application number: PCT/JP2012/057120
(87) International publication number: WO 2012/128269

(57) **Abstract**

A wiring substrate includes an insulating layer (10), an upper wiring pattern (11), and a lower wiring pattern (12), the wiring patterns sandwiching the insulating layer (10). The lower wiring pattern (12) has an interlayer connecting conductor (12A) formed integrally therewith and projecting toward the upper wiring pattern (11) for electrical connection to the upper wiring pattern (11). The interlayer connecting conductor (12A) is joined to the upper wiring pattern (11) in a state intruding into the upper wiring pattern (11) beyond a joining interface between the insulating layer (10) and the upper wiring pattern (11). Thus, the wiring substrate adaptable for a large current is provided without causing degradation of reliability in connection, which may occur by cracking, disconnection, interlayer peeling-off, etc.

## Description

### Technical Field

The present invention relates to a wiring substrate in which a conductor pattern is formed in an insulating layer.

### Background Art

In a wiring substrate, an interlayer connecting conductor (via hole conductor) for electrically connecting wiring patterns in different layers to each other is generally formed by boring a through-hole in the wiring substrate and coating a plating over an inner wall of the through-hole. However, such a method has problems from the viewpoint of productivity, economic efficiency, and so on because chemicals used in the plating process is expensive and the processing time is relatively long.

To cope with the above-mentioned problems, there is proposed, for example, a method of forming an interlayer connecting conductor by filling a conductive paste, which contains metal powder, into a through-hole formed in an insulating layer of a wiring substrate. In the proposed method, after forming the interlayer connecting conductor by filling the conductive paste into the through-hole, the interlayer connecting conductor is compacted by pressing a wiring circuit layer made of a metal foil against the interlayer connecting conductor. At that time, there is a risk that, with the pressing of the wiring circuit layer, the conductor paste in the interlayer connecting conductor may spread out into a gap between the insulating layer and the wiring circuit layer, and adhesion between the insulating layer and the wiring circuit layer may lower, thus causing a conduction failure in the wiring substrate.

Patent Document 1 discloses a wiring substrate having features to prevent the conductor paste of the interlayer connecting conductor from spreading out to the surroundings of the interlayer connecting conductor, and to avoid an adhesion failure from occurring between the wiring circuit layer and the insulating layer. Fig. 1 is a schematic sectional view of the wiring substrate disclosed in Patent Document 1. In the wiring substrate illustrated in Fig. 1, insulating layers 501A and 501B, each containing a thermosetting resin, are laminated, and a wiring circuit layer 502 is buried in the surface of each insulating layer.

Through-holes for connecting the wiring circuit layers 502 to each other are formed in the insulating layers 501A and 501B. An interlayer connecting conductor 503 is formed in each through-hole by filling a conductor material, which contains metal powder, into the through-hole. Furthermore, the wiring circuit layer 502 has a recess 504 into which the interlayer connecting conductor 503 intrudes to be buried therein. The recess 504 serves to prevent the conductor paste of the interlayer connecting conductor 503 from spreading out to the surroundings of the interlayer connecting conductor 503.

### Citation List

### Patent Document

Patent Document 1: Japanese Unexamined Patent Application Publication No. 2003-8225

### Summary of Invention

### Technical Problem

Patent Document 1 accompanies with a risk that, if the recess 504 formed in the wiring circuit layers 502 is too shallow, the effect of preventing the spreading-out of the conductor paste would be reduced, and if it is too deep, the thickness of the wiring circuit layers 502 would be reduced and the strength of the wiring circuit layers 502 would be reduced. In other words, Patent Document 1 accompanies with a risk that connection reliability in the wiring substrate may degrade because the adhesion failure between the wiring circuit layers and the insulating layer cannot be sufficiently avoided.

Moreover, in Patent Document 1, the interlayer connecting conductor is formed by filling the conductor paste into the through-hole. However, because the conductor paste is made of the resin containing the metal powder, an amount of metal component in the interlayer connecting conductor is relatively small. As a result, a resistance value of the interlayer connecting conductor increases. This raises another problem that the interlayer connecting conductor impedes flow of a current, thus making the wiring substrate not adaptable for a large current.

Accordingly, an object of the present invention is to provide a wiring substrate that is adaptable for a large current without causing degradation of reliability in connection, which may occur by cracking, disconnection, interlayer peeling-off, etc.

### Solution to Problem

The present invention provides a wiring substrate comprising an insulating layer, a first conductive pattern and a second conductive pattern disposed in sandwiching relation to the insulating layer, and an interlayer connecting conductor penetrating through the insulating layer in a direction of thickness thereof and electrically connecting the first conductive pattern and the second conductive pattern to each other, wherein the interlayer connecting conductor is formed integrally with the first conductive pattern, and the interlayer connecting conductor is joined to the second conductive pattern in a state intruding into the second conductive pattern beyond a joining interface between the insulating layer and the second conductive pattern.

With the features described above, the interlayer connecting conductor electrically connecting the first conductive pattern and the second conductive pattern to each other is formed integrally with the first conductive pattern, and the interlayer connecting conductor is in a state intruding into the second conductive pattern. In other words, a joining interface between the interlayer connecting conductor and the second conductive pattern is not coplanar with the joining interface between the insulating layer and the second conductive pattern. Here, the expression "formed integrally" implies that the interlayer connecting conductor and the first conductive pattern are formed of a single integral metal member, and there is no joining interface therebetween.

With expansion and contraction depending on temperature changes (overheating and cooling), stress generates in a joining portion between the insulating layer and the conductive pattern due to a difference in expansion coefficient therebetween. If the joining interface between the interlayer connecting conductor and the second conductive pattern is coplanar with the joining interface between the insulating layer and the second conductive pattern, there is a risk that the generated stress may concentrate at the joining interface and peeling-off may occur at the joining interface. This result in a possibility of causing a conduction failure between the first conductive pattern and the second conductive pattern, or generating cracks in the wiring substrate.

To cope with the above-mentioned problems, the interlayer connecting conductor is caused to intrude into the second conductive pattern such that the joining interface between the interlayer connecting conductor and the second conductive pattern and the joining interface between the insulating layer and the second conductive pattern are positioned in different planes. With such an arrangement, the generated stress can be distributed. It is hence possible to prevent the conduction failure caused by the peeling-off or the cracks generated in the wiring substrate.

Furthermore, when conductive patterns in different layers are connected to each other, as in the related art, by an interlayer connecting conductor that is formed by filling metal powder into a through-hole, a resistance value in a connecting portion between the conductive pattern and the interlayer connecting conductor increases because they are made of different materials. In contrast, according to the present invention, since a connecting conductor serving as the interlayer connecting conductor is formed integrally with the first conductive pattern, a resistance value in a connecting portion between the first conductive pattern and the interlayer connecting conductor can be prevented from increasing, and the above-mentioned problem with the related art can be avoided.

Moreover, since the interlayer connecting conductor and the second conductive pattern are formed integrally with each other unlike the related-art using the method of filling the conductive paste, an amount of metal component contained in the interlayer connecting conductor can be increased, whereby a resistance value of the interlayer connecting conductor can be reduced.

In the wiring substrate according to the present invention, the insulating layer may be made up of plural layers, and the conductive pattern may be formed on a surface of an uppermost one of the plural layers constituting the insulating layer.

With the features described above, a conduction failure can be prevented in the surface of the uppermost one of the plural insulating layers to which an electronic component is generally mounted.

In the wiring substrate according to the present invention, preferably, the interlayer connecting conductor and the second conductive pattern are electrically connected to each other in at least parts thereof through a conductive adhesive.

With the feature described above, connection reliability between the interlayer connecting conductor and the second conductive pattern can be improved because they are electrically connected to each other through the conductive adhesive.

In the wiring substrate according to the present invention, preferably, an organic coating is formed in at least part of a joining interface between the interlayer connecting conductor and the second conductive pattern.

With the feature described above, since oxidation in a connecting portion between the interlayer connecting conductor and the second conductive pattern can be suppressed, a resistance value in that connecting portion can be avoided from increasing.

In the wiring substrate according to the present invention, preferably, at least the interlayer connecting conductor is subjected to surface treatment. The surface treatment is, for example, roughing, blackening, coupling, and formation of an organic coating.

With the feature described above, since the interlayer connecting conductor is subjected to the surface treatment, adhesion between the insulating resin and the interlayer connecting conductor increases, and peeling-off can be suppressed which may occur by stress generated due to a difference in expansion coefficient between two adjacent members. It is hence possible to prevent a conduction failure caused by the peeling-off, cracks generated in the wiring substrate, etc. The peeling-off occurred between the insulating resin and the interlayer connecting conductor leads to the conduction failure with a high probability. Thus, the surface of the interlayer connecting conductor is an essential region where the surface treatment is to be performed. In addition to the surface of the interlayer connecting conductor, the surface of the first conductive pattern and the surface of the second conductive pattern may also be subjected to the surface treatment.

In the wiring substrate according to the present invention, the first conductive pattern may have lands formed integrally therewith on side close to the insulating layer, and the wiring substrate may further comprise an electronic component mounted to the lands and disposed inside the insulating layer.

With the features described above, since the electronic component can be incorporated inside the insulating layer, the size of the wiring substrate can be reduced.

In the wiring substrate according to the present invention, preferably, the interlayer connecting conductor intrudes into the second conductive pattern by 10 µm or more at a most deeply intruding portion thereof.

With the feature described above, since an amount by which the interlayer connecting conductor intrudes into the second conductive pattern at the most deeply intruding portion thereof is set to be 10 µm or more, the occurrence of a failure due to the peeling-off between the interlayer connecting conductor and the second conductive pattern can be suppressed, and the connection reliability in the wiring substrate can be increased.

### Advantageous Effects of Invention

According to the present invention, since the joining interface between the interlayer connecting conductor and the second conductive pattern and the joining interface between the second conductive pattern and the insulating layer are positioned in different planes, stress generated due to a difference in expansion coefficient between two adjacent members can be distributed. It is hence possible to prevent the interlayer peeling-off and the conduction failure attributable to the stress, and to increase the connection reliability in the wiring substrate. In addition, since the interlayer connecting conductor is formed integrally with the first conductive pattern, an amount of metal component contained in the interlayer connecting conductor can be increased, whereby a resistance value of the interlayer connecting conductor can be reduced. Brief Description of Drawings

[Fig. 1] Fig. 1 is a schematic sectional view of a wiring substrate described in Patent Document 1.
[Fig. 2] Fig. 2 is a schematic sectional view of a wiring substrate according to Embodiment 1.
[Fig. 3] Fig. 3 illustrates, in enlarged scale, a circular portion surrounded by a one-dot-chain line in Fig. 2.
[Fig. 4] Fig. 4 successively illustrates a series of manufacturing steps for the wiring substrate according to Embodiment 1.
[Fig. 5] Fig. 5 is a graph depicting the result of carrying out thermal shock tests on the wiring substrate according to Embodiment 1.
[Fig. 6] Fig. 6 is a graph depicting the relationship between the diameter of an interlayer connecting conductor and connection reliability at an intrusion amount of 10 µm.
[Fig. 7] Fig. 7 is a graph depicting the relationship between the thickness of an upper wiring pattern and connection reliability at the intrusion amount of 10 µm.
[Fig. 8] Fig. 8 is a graph depicting the relationship between the upper wiring pattern and the intrusion amount.
[Fig. 9] Fig. 9 is a schematic sectional view of a wiring substrate according to Embodiment 2.
[Fig. 10] Fig. 10 is a graph depicting the result of carrying out thermal shock tests on the wiring substrate according to Embodiment 2.
[Fig. 11] Fig. 11 is a schematic sectional view of a wiring substrate according to Embodiment 3.
[Fig. 12] Fig. 12 successively illustrates a series of manufacturing steps for the wiring substrate according to Embodiment 3.
[Fig. 13] Fig. 13 is a schematic sectional view of a wiring substrate according to Embodiment 4.
[Fig. 14] Fig. 14 successively illustrates a series of manufacturing steps for the wiring substrate according to Embodiment 4.

### Description of Embodiments

The wiring substrate according to the present invention includes an insulating layer made of an insulating resin, and a conductive wiring pattern (conductive pattern) disposed on the insulating layer. The insulating layer may be a single layer or made up of plural layers. The insulating resin forming the insulating layer is, for example, a glass epoxy resin, an epoxy resin, a phenol resin, a cyanate resin, or a polyimide resin. Among those examples, the polyimide resin is particularly preferable in exhibiting superior heat resistance after being hardened.

The wiring substrate electrically connects, through the wiring pattern, an electronic component mounted to the surface of the insulating layer and a main substrate (e.g., a mother board) to which the wiring substrate is mounted. The electronic component mounted to the wiring substrate is, for example, an active element such as a silicon semiconductor element or a gallium arsenide semiconductor element, or a passive element such as a capacitor or an inductor.

### (Embodiment 1)

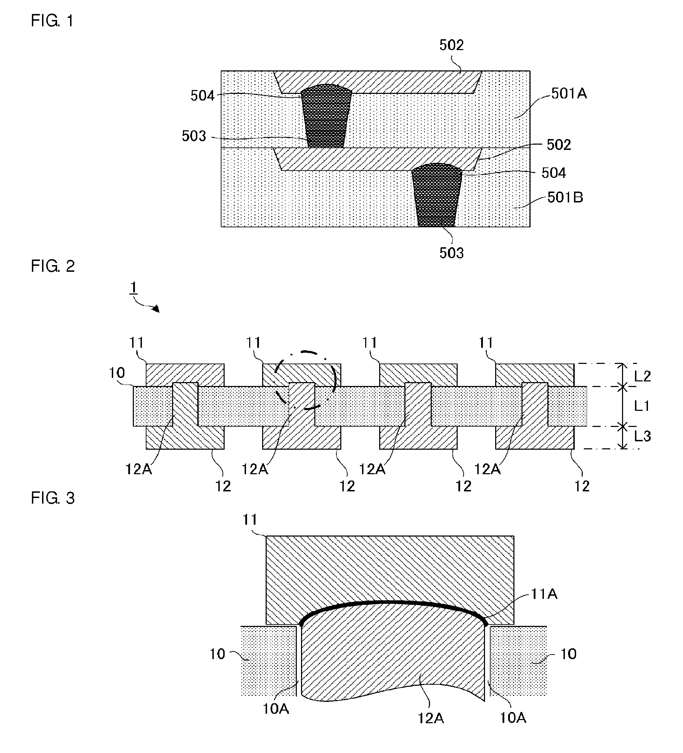

Fig. 2 is a schematic sectional view of a wiring substrate according to Embodiment 1. Fig. 3 illustrates, in enlarged scale, a circular portion surrounded by a one-dot-chain line in Fig. 2. It is to be noted that, in Fig. 3, though individual members are actually in a state of being closely contacted with each other, the members are drawn with gaps left at joining boundaries between them for convenience of explanation.

In a wiring substrate 1 according to Embodiment 1, an upper wiring pattern 11 is formed at an upper surface of an insulating layer 10, and a lower wiring pattern 12 is formed at a lower surface of the insulating layer 10. The upper surface of the insulating layer 10 serves as the above-mentioned surface to which the electronic component is mounted.

The insulating layer 10 has a thickness of 0.10 mm and includes a cylindrical through-via 10A formed therein. An interlayer connecting conductor 12A formed integrally with the lower wiring pattern 12, as described below, is inserted to the through-via 10A. The upper wiring pattern 11 and the lower wiring pattern 12 formed respectively at the upper and lower surfaces of the insulating layer 10 are electrically connected to each other by the interlayer connecting conductor 12A.

The wiring pattern 11 is formed at the upper surface of the insulating layer 10 and has a thickness of 0.10 mm. A distal end portion of the later-described interlayer connecting conductor 12A, projecting out from the insulating layer 10, intrudes into the upper wiring pattern 11 at each position that is aligned with the through-via 10A formed in the insulating layer 10 when viewed in the direction of thickness thereof. While a joining interface 11A between the upper wiring pattern 11 and the interlayer connecting conductor 12A has a circular arc shape in section as illustrated in Fig. 3, the joining interface 11A may have a rectangular shape.

The lower wiring pattern 12 is formed at the lower surface of the insulating layer 10 and has a thickness of 0.10 mm. The interlayer connecting conductor 12A is formed integrally with the lower wiring pattern 12. In other words, the lower wiring pattern 12 and the interlayer connecting conductor 12A are formed of a single integral metal member, and there is no joining interface therebetween.

The interlayer connecting conductor 12A has a cylindrical shape with a diameter of 0.6 mm and a length of 0.2 mm. As illustrated in Fig. 3, the distal end portion of the interlayer connecting conductor 12A has a circular arc shape. The interlayer connecting conductor 12A is inserted to the through-via 10A formed in the insulating layer 10. Thus, the distal end portion of the interlayer connecting conductor 12A projecting out from the upper surface of the insulating layer 10 is burred in the upper wiring pattern 11.

By forming the lower wiring pattern 12 and the interlayer connecting conductor 12A integrally with each other, an amount of metal component contained therein can be increased and a resistance value of the interlayer connecting conductor can be reduced in comparison with the case where the interlayer connecting conductor is formed by filling the conductor paste, which is made of the resin containing the metal powder, into the through-hole.

While the interlayer connecting conductor 12A has the cylindrical shape in this embodiment, it may have a rectangular columnar shape. Furthermore, the distal end portion of the interlayer connecting conductor 12A may have a planar shape.

Thus, since the upper wiring pattern 11 is buried in the interlayer connecting conductor 12A, a joining interface between the interlayer connecting conductor 12A and the upper wiring pattern 11 is positioned in a plane different from a joining interface between the insulating layer 10 and the upper wiring pattern 11. It is therefore possible to avoid stress generated due to a difference in expansion coefficient from concentrating at the joining interface, and to prevent a conduction failure caused by peeling-off attributable to the stress, cracks generated in the wiring substrate 1, etc.

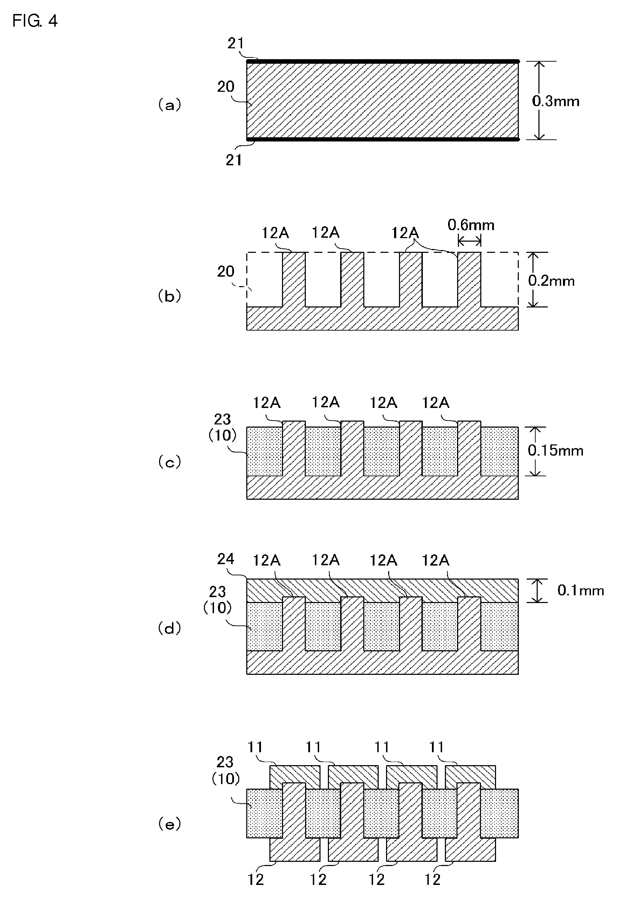

A method of manufacturing the wiring substrate 1 will be described below. Fig. 4 successively illustrates a series of manufacturing steps for the wiring substrate according to Embodiment 1.

In a first step (Fig. 4(a)), dry film resists 21 each having a thickness of 15 µm are pasted to both surfaces of a copper plate 20 having a thickness of 0.3 mm, which surfaces are opposed to each other in the direction of thickness of the copper plate. It is to be noted that Fig. 4 illustrates the copper plate 20 when viewed from a side.

Next, in a second step (Fig. 4(b)), the copper plate 20 including the dry film resists 21 pasted thereto is etched from one surface side such that the cylindrical interlayer connecting conductors 12A, each having the diameter of 0.6 mm and the length of 0.2 mm, remain on the one surface side.

In a third step (Fig. 4(c)), holes (not illustrated), each having a diameter of 0.6 mm, are formed in an insulating resin 23 having a thickness of 0.15 mm, and the insulating resin 23 is laminated on the copper plate 20 that has been subjected to the etching in the second step. The insulating resin 23 becomes the insulating layer 10.

In a fourth step (Fig. 4(d)), a copper plate 24 having a thickness of 0.1 mm is placed on an upper surface of the insulating resin 23 (i.e., the insulating layer 10). In such a state, they are subjected to lamination molding for 1 hour at 180°C and 100 kN. As a result, the distal end portion of the interlayer connecting conductor 12A is caused to intrude into the copper plate 24, and the above-mentioned joining interface 11A is formed in a circular arc shape.

In a fifth step (Fig. 4(e)), patterns are formed on both surfaces of a laminate, obtained in the fourth step, by a subtractive process (i.e., a process of removing unnecessary portions while leaving a circuit). As a result, the copper plate 20 is formed into the lower wiring pattern 12, and the copper plate 24 is formed into the upper wiring pattern 11. The wiring substrate 1 is thus completed.

An intrusion amount by which the interlayer connecting conductor 12A is buried in the upper wiring pattern 11 will be described below. The intrusion amount is preferably set to be not more than 50% of the thickness of the upper wiring pattern 11. That point will be described in more detail below in connection with practical values.

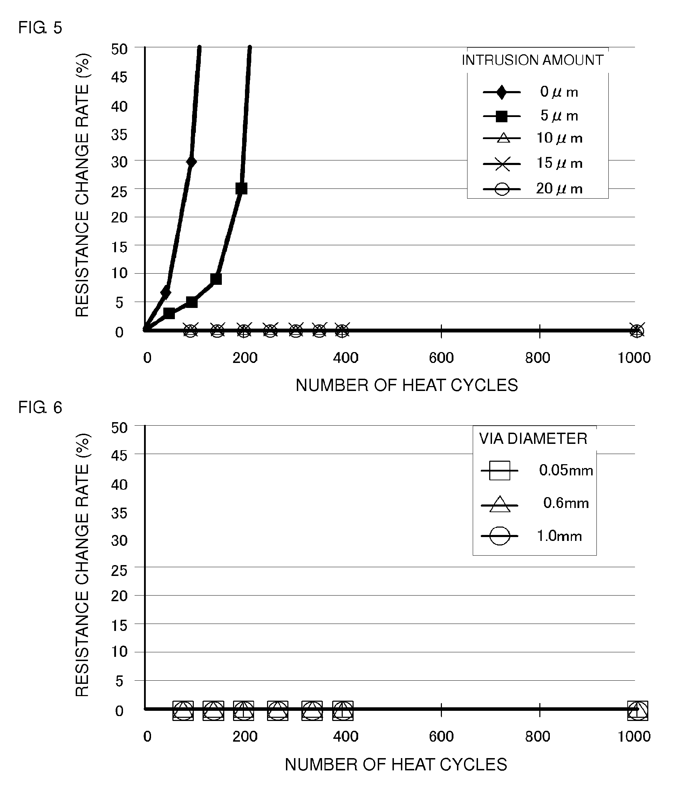

Fig. 5 is a graph depicting the result of carrying out thermal shock tests on the wiring substrate 1 according to Embodiment 1. In the graph of Fig. 5, the vertical axis represents a resistance change rate (%) of the wiring substrate 1, and the horizontal axis represents the number of heat cycles in the thermal shock tests.

As seen from Fig. 5, when the intrusion amount of the interlayer connecting conductor 12A into the upper wiring pattern 11 is 0 µm or 5 µm, the resistance change rate increases as the number of heat cycles increases. On the other hand, when the intrusion amount of the interlayer connecting conductor 12A into the upper wiring pattern 11 is 10 µm, 15 µm or 20 µm, the resistance change rate hardly changes regardless of the number of heat cycles. Thus, the intrusion amount is preferably not less than 10 µm for the reason that connection reliability degrades at a smaller value of the intrusion amount.

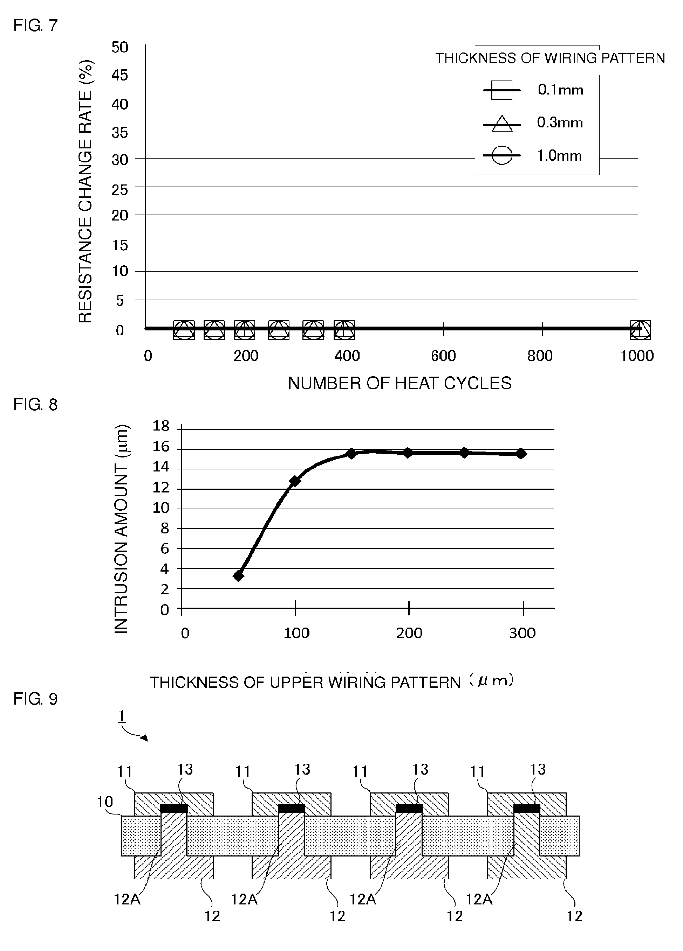

Moreover, the intrusion amount is preferably set to be not less than 10 µm regardless of the diameter of the interlayer connecting conductor 12A and the thickness of the upper wiring pattern 11. Fig. 6 is a graph depicting the relationship between the diameter of the interlayer connecting conductor 12A and the connection reliability at the intrusion amount of 10 µm. Fig. 7 is a graph depicting the relationship between the thickness of the upper wiring pattern 11 and the connection reliability at the intrusion amount of 10 µm.

The reason why the connection reliability increases at the intrusion amount of not less than 10 µm resides in that the joining interface between the upper wiring pattern 11 and the interlayer connecting conductor 12A is not coplanar with the joining interface between the insulating layer 10 and the upper wiring pattern 11, which are different in thermal expansion coefficient from each other. Accordingly, the above-mentioned advantageous effect can be obtained regardless of the diameter of the interlayer connecting conductor 12A and the thickness of the upper wiring pattern 11.

For example, as seen from Fig. 6, when the diameter of the interlayer connecting conductor 12A is any of 0.05 mm, 0.6 mm and 1.0 mm, the resistance change rate hardly changes regardless of the number of heat cycles. Furthermore, as seen from Fig. 7, when the thickness of the upper wiring pattern 11 is any of 0.1 mm, 0.3 mm and 1.0 mm, the resistance change rate hardly changes regardless of the number of heat cycles.

While the intrusion amount is preferably not less than 10 µm, the thickness of the upper wiring pattern 11 is preferably set to be not less than 100 µm on that condition. Fig. 8 is a graph depicting the relationship between the upper wiring pattern 11 and the intrusion amount. In the graph of Fig. 8, the vertical axis represents the intrusion amount, and the horizontal axis represents the thickness of the upper wiring pattern 11. As seen from Fig. 8, when the intrusion amount is 10 µm, the thickness of the upper wiring pattern 11 is about 100 µm. When the thickness of the upper wiring pattern 11 is not less than 100 µm, the intrusion amount is held substantially constant. Thus, the intrusion amount can be obtained as an optimum value of not less than 10 µm when the thickness of the upper wiring pattern 11 is not less than 100 µm.

### (Embodiment 2)

A wiring substrate according to Embodiment 2 will be described below. The wiring substrate 1 according to Embodiment 2 differs from that according to Embodiment 1 in making the interlayer connecting conductor 12A and the upper wiring pattern 11 electrically connected through a conductive adhesive. Only different point will be described below.

Fig. 9 is a schematic sectional view of the wiring substrate 1 according to Embodiment 2. In the wiring substrate 1 according to Embodiment 2, as illustrated in Fig. 9, a conductive adhesive 13 is coated on the distal end portion of the interlayer connecting conductor 12A. The conductive adhesive 13 is, for example, a low-resistance conductive paste made of nano-silver or nano-copper. It is to be noted that the conductive adhesive 13 may be made of a resin composition containing metal powder.

Since the conductive adhesive 13 is coated on the distal end portion of the interlayer connecting conductor 12A, the upper wiring pattern 11 and the interlayer connecting conductor 12A are electrically connected to each other through the conductive adhesive 13. With the presence of the conductive adhesive 13 coated on the interlayer connecting conductor 12A, the connection reliability of the interlayer connecting conductor 12A can be further increased.

A method of manufacturing the wiring substrate 1 according to Embodiment 2 is substantially the same as that in Embodiment 1. The wiring substrate 1 according to Embodiment 2 can be manufactured by coating the conductive adhesive 13 on the distal end portion of the interlayer connecting conductor 12A in the third step illustrated in Fig. 4(c).

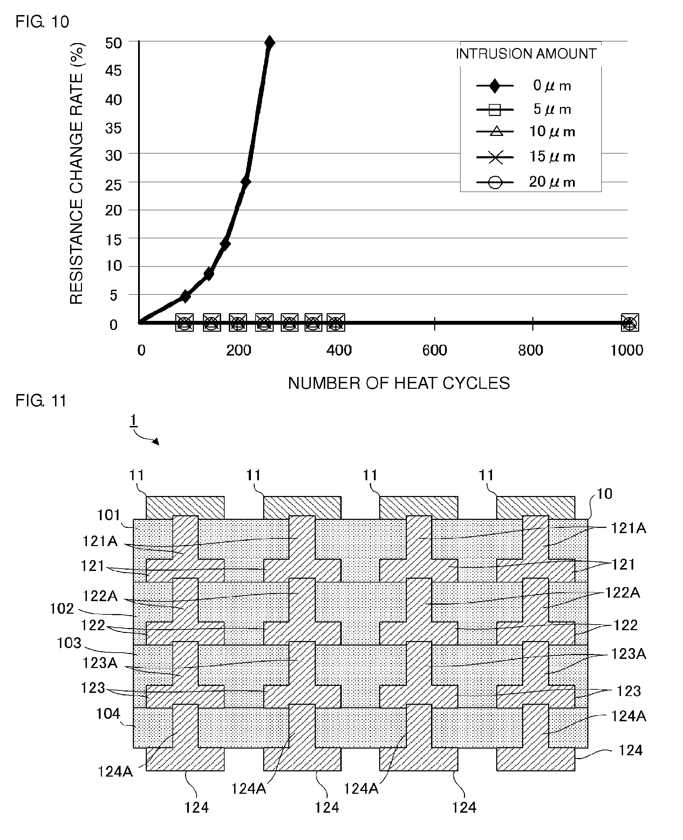

While the intrusion amount is set to be not less than 10 µm in Embodiment 1, the intrusion amount can be set to be not less than 5 µm in the case where the conductive adhesive 13 is coated. Fig. 10 is a graph depicting the result of carrying out thermal shock tests on the wiring substrate 1 according to Embodiment 2. As seen from Fig. 10, when the intrusion amount is not less than 5 µm, the resistance change rate hardly changes regardless of the number of heat cycles. Thus, the intrusion amount is preferably not less than 5 µm in Embodiment 2 for the reason that the connection reliability degrades at a smaller value of the intrusion amount.

### (Embodiment 3)

A wiring substrate according to Embodiment 3 will be described below. The wiring substrate 1 according to Embodiment 3 is different from that according to Embodiment 1 in that the insulating layer 10 has a multilayered structure, and a wiring pattern is formed between the adjacent layers. Only those different points will be described below.

Fig. 11 is a schematic sectional view of the wiring substrate 1 according to Embodiment 3. As illustrated in Fig. 11, the insulating layer 10 of the wiring substrate 1 according to Embodiment 3 is constituted as a laminate including a first layer 101, a second layer 102, a third layer 103, and a fourth layer 104, which are successively positioned in the mentioned order from the surface side of the insulating layer 10.

The upper wiring pattern 11 is formed at an upper surface of the first layer 101, and a lower wiring pattern 121 is formed at a lower surface of the first layer 101. An interlayer connecting conductor 121A is formed integrally with the lower wiring pattern 121. A distal end portion of the interlayer connecting conductor 121A projects toward the upper wiring pattern 11 from the first layer 101 such that the distal end portion thereof intrudes into the upper wiring pattern 11.

A lower wiring pattern 122 is formed at a lower surface of the second layer 102. An interlayer connecting conductor 122A is formed integrally with the lower wiring pattern 122. A distal end portion of the interlayer connecting conductor 122A projects toward the lower wiring pattern 121 from the second layer 102 such that the distal end portion of the interlayer connecting conductor 122A intrudes into the lower wiring pattern 121.

A lower wiring pattern 123 is formed at a lower surface of the third layer 103. An interlayer connecting conductor 123A is formed integrally with the lower wiring pattern 123. A distal end portion of the interlayer connecting conductor 123A projects toward the lower wiring pattern 122 from the third layer 103 such that the distal end portion of the interlayer connecting conductor 123A intrudes into the lower wiring pattern 122.

A lower wiring pattern 124 is formed at a lower surface of the fourth layer 104. An interlayer connecting conductor 124A is formed integrally with the lower wiring pattern 124. A distal end portion of the interlayer connecting conductor 124A projects toward the lower wiring pattern 123 from the fourth layer 104 such that the distal end portion of the interlayer connecting conductor 124A intrudes into the lower wiring pattern 123.

In the wiring substrate 1 according to Embodiment 3, as described above, the wiring patterns have such a multilayered structure that, looking at the wiring pattern of each layer, the distal end portion of the interlayer connecting conductor formed integrally with the wiring pattern in the underlying layer is buried in the relevant wiring pattern. Therefore, as in Embodiment 1, it is possible to avoid peeling-off between the laminated layers, which may occur by stress generated due to a difference in expansion coefficient, and to prevent the occurrence of a conduction failure, cracking, etc.

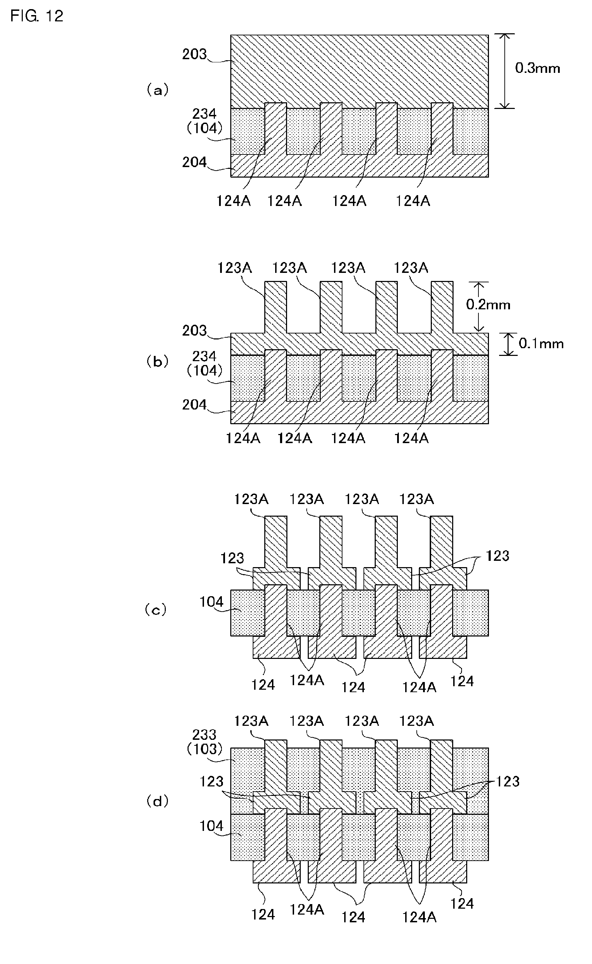

Fig. 12 successively illustrates a series of manufacturing steps of the wiring substrate 1 according to Embodiment 3.

As illustrated in Fig. 12(a), a copper plate 204 is etched to form the interlayer connecting conductors 124A, and an insulating resin 234 is laminated on the copper plate 204 such that the distal end portion of each interlayer connecting conductor 124A projects out from the insulating resin 234 by 0.05 mm. The insulating resin 234 becomes the fourth layer 104 in Fig. 11.

A copper plate 203 having a thickness of 0.3 mm is placed on an upper surface of the insulating resin 234, and they are subjected to lamination molding for 1 hour at 180°C and 100 kN. As a result, the distal end portion of the interlayer connecting conductor 124A is caused to intrude into the copper plate 203.

Next, as illustrated in Fig. 12(b), a dry film resist (not illustrated) having a thickness of 15 µm is pasted to an upper surface of the copper plate 203. The copper plate 203 is then etched such that the cylindrical interlayer connecting conductors 123A, each having the diameter of 0.6 mm and the length of 0.2 mm, remain on the upper surface side of the copper plate 203.

Next, as illustrated in Fig. 12(c), patterns are formed on both surfaces of a laminate, obtained as illustrated in Fig. 12(b), by the subtractive process. As a result, the copper plate 204 is formed into the lower wiring pattern 124, and the copper plate 203 is formed into the lower wiring pattern 123.

Next, as illustrated in Fig. 12(d), holes (not illustrated), each having a diameter of 0.6 mm, are formed in an insulating resin 233 having a thickness of 0.15 mm, and the insulating resin 233 is laminated on the fourth layer 104 such that the interlayer connecting conductors 123A formed in Fig. 12(c) are inserted to the holes, respectively. The insulating resin 233 becomes the third layer 103 in Fig. 11.

The wiring substrate 1 according to Embodiment 3, illustrated in Fig. 11, can be formed by successively repeating the steps described above with reference to Fig. 12. Thus, the size of the wiring substrate 1 can be further reduced by forming the wiring patterns inside the insulating layer 10 in the multilayered structure.

### (Embodiment 4)

A wiring substrate according to Embodiment 4 will be described below. The wiring substrate 1 according to Embodiment 4 is different from that according to Embodiment 3 in mounting electronic components inside the insulating layer 10 of the wiring substrate 1 according to Embodiment 3. Only such a different point will be described below.

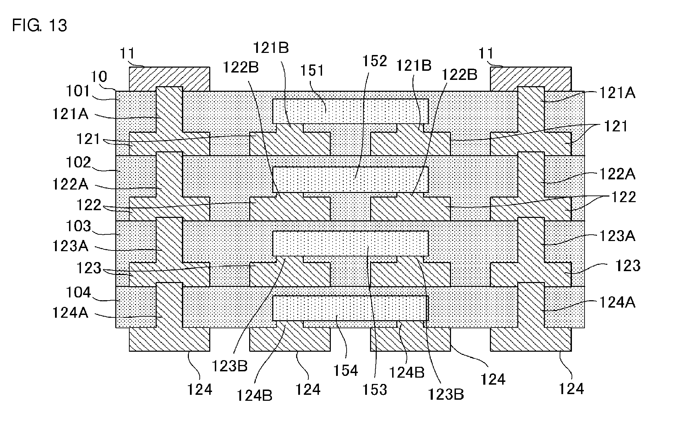

Fig. 13 is a schematic sectional view of the wiring substrate 1 according to Embodiment 4. As in Embodiment 3, the insulating layer 10 of the wiring substrate 1 according to Embodiment 4 is constituted as a laminate including the first layer 101, the second layer 102, the third layer 103, and the fourth layer 104, which are successively positioned in the mentioned order from the surface side of the insulating layer 10.

In addition to the interlayer connecting conductors 121A, 122A, 123A and 124A, lands 121B, 122B, 123B and 124B are formed integrally with the lower wiring patterns 121, 122, 123 and 124 that are formed at lower surfaces of the first layer 101, the second layer 102, the third layer 103, and the fourth layer 104, respectively.

Electronic components 151, 152, 153 and 154 are mounted respectively to the lands 121B, 122B, 123B and 124B in the individual layers. The electronic components 151, 152, 153 and 154 are disposed respectively in the first layer 101, the second layer 102, the third layer 103, and the fourth layer 104. Thus, with the electronic components 151, 152, 153 and 154 incorporated in the insulating resin, the size of the wiring substrate 1 can be reduced.

The electronic components 151, 152, 153 and 154 are, for example, active elements such as silicon semiconductor elements or gallium arsenide semiconductor elements, or passive elements such as capacitors or inductors.

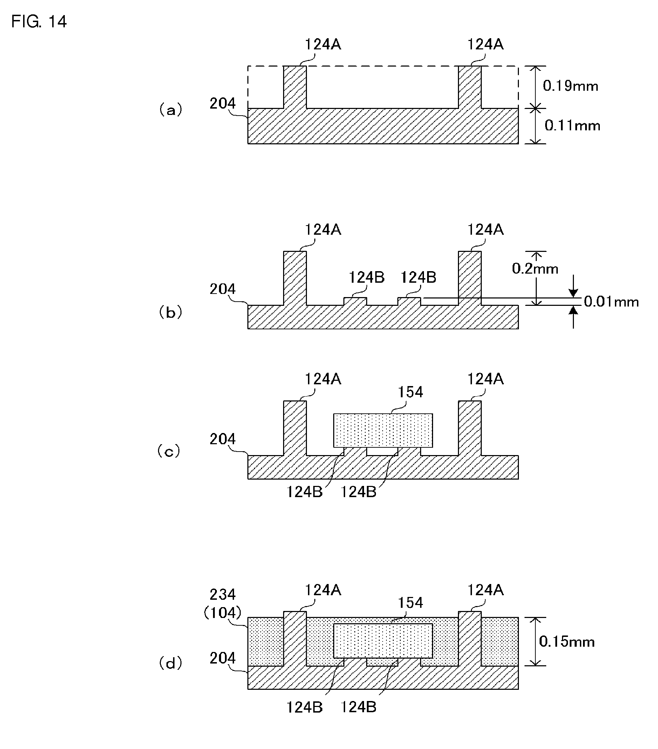

Fig. 14 successively illustrates a series of manufacturing steps for the wiring substrate 1 according to Embodiment 4.

In a first step (Fig. 14(a)), dry film resists (not illustrated) each having a thickness of 15 µm are pasted to both surfaces of a copper plate 20 having a thickness of 0.3 mm, which surfaces are opposed to each other in the direction of thickness of the copper plate. The copper plate 204 including the dry film resists pasted thereto is etched from one surface side such that the cylindrical interlayer connecting conductors 124A, each having the diameter of 0.6 mm and the length of 0.19 mm, remain on the one surface side.

In a second step (Fig. 14(b)), the copper plate 204 having been subjected to the etching in Fig. 14(a) is further etched to form lands 124B each having a thickness of 0.01 mm. With the step of forming the lands 124B, the interlayer connecting conductor 124A having been formed in the length of 0.19 mm is caused to have the length of 0.2 mm.

In a third step (Fig. 14(c)), the electronic component 154 is mounted to the formed lands 124B. Thereafter, in a fourth step (Fig. 14(d)), an insulating resin 234 is laminated on the copper plate 204. In Embodiment 4, the insulating resin 234 is in a liquid phase. After coating the insulating resin 234 over the copper plate 204, the insulating resin 234 is subjected to debubbling under vacuum and then heated to such an extent that the insulating resin 234 in a semi-hardened state encapsulates the electronic component 154. At that time, the insulating resin 234 has a thickness of 0.15 mm.

Thereafter, as in the step (see Fig. 12) described above in Embodiment 3, a copper plate 203 having a thickness of 0.3 mm is placed on the insulating resin 234, and they are subjected to lamination molding for 1 hour at 180°C and 100 kN. The wiring substrate 1 illustrated in Fig. 13 is formed by subsequently repeating the above-described steps from the step illustrated in Fig. 14(a). Thus, with the electronic components incorporated in the insulating resin, the size of the wiring substrate 1 can be reduced.

While the wiring substrate according to the present invention has been described in detail above, practical structures of the wiring substrate 1 can be modified in design as required. The operations and the advantageous effects stated in the foregoing embodiments are merely explained as most preferable operations and advantageous effects obtained with the present invention. In other words, the operations and the advantageous effects of the present invention are not limited to those described above in the embodiments.

### Reference Signs List

- 1: - wiring substrate
- 10: - insulating layer
- 11: - upper wiring pattern (second conductive pattern)
- 11A: - joining interface
- 12: - lower wiring pattern (first conductive pattern)
- 12A: - interlayer connecting conductor
- 13: - conductive adhesive

## Claims

1. A wiring substrate comprising:
an insulating layer;
a first conductive pattern and a second conductive pattern disposed in sandwiching relation to the insulating layer; and
an interlayer connecting conductor penetrating through the insulating layer in a direction of thickness thereof and electrically connecting the first conductive pattern and the second conductive pattern to each other,
wherein the interlayer connecting conductor is formed integrally with the first conductive pattern, and the interlayer connecting conductor is joined to the second conductive pattern in a state intruding into the second conductive pattern beyond a joining interface between the insulating layer and the second conductive pattern.

2. The wiring substrate according to Claim 1, wherein the insulating layer is made up of plural layers, and
the second conductive pattern is formed on a surface of an uppermost one of the plural layers constituting the insulating layer.

3. The wiring substrate according to Claim 1 or 2, wherein the interlayer connecting conductor and the second conductive pattern are electrically connected to each other in at least parts thereof through a conductive adhesive.

4. The wiring substrate according to Claim 2 or 3, wherein the first conductive pattern has lands formed integrally therewith on side close to the insulating layer, and
the wiring substrate further comprises an electronic component mounted to the lands and disposed inside the insulating layer.

5. The wiring substrate according to any one of Claims 1 to 4, wherein the interlayer connecting conductor intrudes into the second conductive pattern by 10 µm or more at a most deeply intruding portion thereof.

6. The wiring substrate according to any one of Claims 1 to 5, wherein an organic coating is formed in at least part of a joining interface between the interlayer connecting conductor and the second conductive pattern.

7. The wiring substrate according to any one of Claims 1 to 6, wherein at least the interlayer connecting conductor is subjected to surface treatment.
